Europäisches Patentamt

European Patent Office

Office européen des brevets

(11) Publication number: **0 290 305 B1**

## EUROPEAN PATENT SPECIFICATION

(45) Date of publication of patent specification: **08.07.92**

(51) Int. Cl.⁵: **H01L 21/74**

(21) Application number: **88400836.8**

(22) Date of filing: **07.04.88**

④⑤ CMOS integrated circuit having a top-side substrate contact and method for making same.

(30) Priority: **01.05.87 US 45610**

(43) Date of publication of application:
**09.11.88 Bulletin 88/45**

(45) Publication of the grant of the patent:
**08.07.92 Bulletin 92/28**

(84) Designated Contracting States:
**AT BE CH DE ES FR GB GR IT LI LU NL SE**

(56) References cited:
**EP-A- 0 216 435**

**IBM TECHNICAL DISCLOSURE BULLETIN, vol. 22, no. 3, August 1979, pages 1004-1007, New York, US; S.D. MALAVIYA et al.: "Bipolar process with self-aligned contacts and isolation"**

(73) Proprietor: **DIGITAL EOUIPMENT CORPORATION**
**146 Main Street**
**Maynard, MA 01754(US)**

(72) Inventor: **Grula, Gregory J.**
**186 Brookfield Road**
**Charlton Massachusetts 01508(US)**
Inventor: **Nasr, André I.**
**8 Gates Avenue**
**Marlboro Massachusetts 01752(US)**

(74) Representative: **Mongrédien, André et al**
**c/o SOCIETE DE PROTECTION DES INVENTIONS 25, rue de Ponthieu**
**F-75008 Paris(FR)**

## Description

## BACKGROUND OF THE INVENTION

### 1. Field of the Invention

The present invention relates generally to the field of manufacturing semiconductor integrated circuit chips and, more specifically, to a method of manufacturing complementary metal oxide semiconductor chips.

### 2. Discussion of the Prior Art

One type of semiconductor integrated circuit known in the prior art is the so-called complementary metal oxide semiconductor or CMOS. The CMOS integrated circuits exhibit relatively fast switching times and low power consumption. As a result, CMOS integrated circuits are well suited for a variety of applications including computers.

A typical CMOS manufacturing process begins with the formation of a high-resistivity epitaxial layer on a low-resistivity substrate. Subsequent conventional photolithographic processing produces a desired electronic component or integrated circuit. For the finished device to operate properly, an electrical connection to the low-resistivity substrate is required. The connection may be made to the exposed bottom of the substrate if a stitched wire bonding process is used to connect fine wires between each of the contact pads on the device and their respective leads in the device package.

However, if the device is packaged using a tape automated bonding (TAB) process, the connection to the substrate must be located opposite the exposed substrate on the "top" surface of the device, that is, the surface which normally includes active components. According to one known method for constructing a top-side substrate connection, all of the processing necessary to construct the active components is done first. Subsequently, a region of impurities which extends laterally around the periphery of the device is introduced through the top surface of the device. The device is then subjected to a conventional heating process to diffuse the region of impurities downwardly into the epitaxial layer. Because the completed active components cannot be exposed to excessive temperature for a sustained period of time without damage, the impurities diffuse only partially through the epitaxial layer and do not actually reach the low-resistivity substrate.

A major disadvantage of this method is that the connection created by the diffused impurities tends to have a relatively large resistance due to the incomplete penetration of the high-resistivity epitaxial layer. The large resistance of the connection enhances the likelihood that the device may experience a condition known as "latch-up" in which the device becomes completely inoperative.

The document EP-A-0 216 435 discloses a method for making an integrated circuit having a top-side substrate contact. The epitaxial layer is masked and dopants implanted to form channel stop regions, which may be used as substrate contacts. Subsequently, additional steps are required to implant dopants to form locations for semiconductor devices.

The document IBM Technical Disclosure Bulletin, vol. 22, p. 1004-1007, 1979 ; SD Malariya et al. : "Bipolar process with self-aligned contacts and isolation" discloses a method for making a transistor with self-aligned contacts to the base, emitter and collector. This document does not disclose any type of contact to the substrate nor a method of making a semiconductor device with such a contact.

## SUMMARY OF THE INVENTION

The present invention provides a new and improved CMOS device having a top-side electrical connection to the substrate and a method for manufacturing the same. A high-resistivity epitaxial layer is applied to a low-resistivity substrate. Subsequently, a region of highly concentrated impurities is introduced around the periphery of the epitaxial layer. Once this high-concentration region is in place and before any active components are formed, the region is heated under controlled conditions such that the impurities diffuse downwardly through the epitaxial layer until they contact the low-resistivity substrate.

As a result, a top-side connection to the substrate is created which has a significantly reduced resistance. The top-side connection is compatible with TAB packaging processes and the reduced resistance of the connection enhances the device's immunity to latch-up.

## BRIEF DESCRIPTION OF THE DRAWINGS

This invention is pointed out with particularity in the appended claims. The above and further advantages of this invention may be better understood by referring to the following description taken in conjunction with the accompanying drawings, in which:

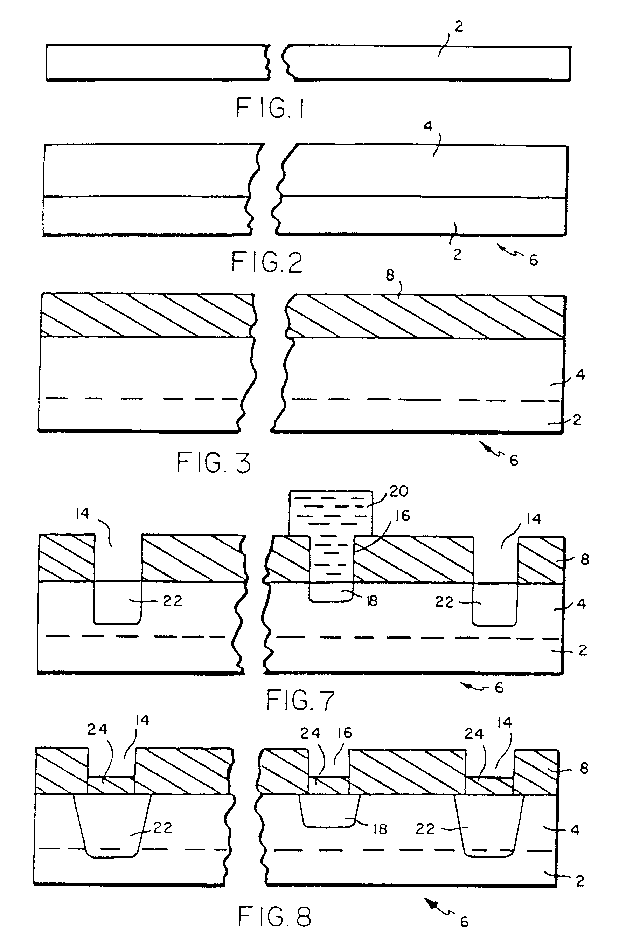

Figures 1 through 8 depict, in cross-section, the successive steps in fabricating a semiconductor device constructed in accordance with the present invention.

## DETAILED DESCRIPTION OF AN ILLUSTRATIVE EMBODIMENT

Figure 1 shows a semiconductor substrate 2 in cross-section. The substrate 2 may comprise, for example a boron-doped substrate having a relatively low resistivity of approximately 0.002-0.008 ohm/cm. As shown in Figure 2, an epitaxial layer 4 of relatively high-resistivity material (10-60 ohms/cm) is subsequently grown on the top surface of the substrate 2. For convenience, the substrate 2 and the epitaxial layer 4 will be referred to collectively as a combination 6.

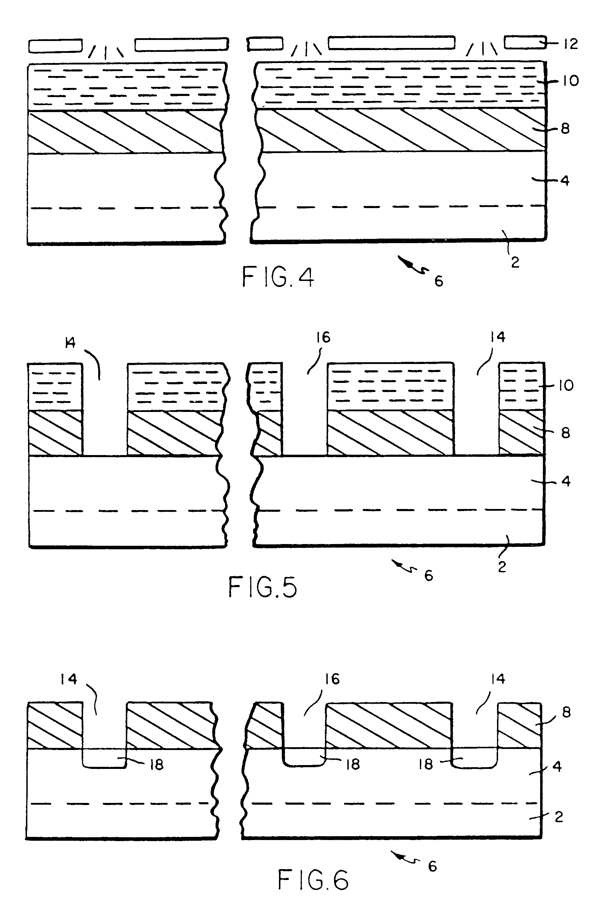

The combination 6 is heated in a conventional process to form an insulating silicon dioxide layer 8 on the top surface of the epitaxial layer 4, as shown in Figure 3. The silicon dioxide layer 8 is then patterned and etched by a conventional photolithographic process. As depicted in Figure 4, a photoresistive layer 10 is applied to the top surface of the silicon dioxide layer 8. Subsequently, light is projected through a mask 12, thereby exposing the photoresistive layer 10 in a preselected pattern.

As depicted in Figure 5, the exposed portions of the photoresistive layer 10, along with the underlying portions of the silicon dioxide layer 8, are then removed leaving two apertures 14 and an aperture 16. The apertures 14 are actually part of a "ring" which extends laterally around the periphery of the silicon dioxide layer 8 and which ultimately will define the location a top-side electrical connection to the substrate 2, as explained below. It should be understood, however, that the top-side connection to the substrate may be disposed at any convenient location on the surface of the dioxide layer 8 and need not extend around the periphery thereof.

In contrast to the apertures 14, the aperture 16 is shown as a possible location for a preselected semiconductor component such as a transistor.

As depicted in Figure 6, a region 18 having a relatively low concentration of impurities is formed in the portions of the epitaxial layer 4 which underlie each of the apertures 14 and 16. The regions 18 may be formed, for example, by a conventional ion implantation process. By using a relatively low implantation energy, the depth of the regions 18 remains relatively shallow.

Subsequently, a new photoresistive layer 20 is applied to the silicon dioxide layer 8, as shown in Figure 7. In contrast to Figure 4, however, the photoresistive layer 20 is patterned such that it covers only the aperture 16 and other like apertures, that is, other apertures which correspond to locations for semiconductor components. In other words, all apertures except apertures 14 (which define the location of the substrate connection) are covered by the photoresistive layer 20. At this point, a relatively high concentration of impurities is introduced through the apertures 14, thereby forming a high-concentration region 22 in the portions of the epitaxial layer 4 which underlie the apertures 14. As above, a conventional ion implantation process may be used to form the high-concentration region 22.

The photoresistive layer 20 is removed and the combination 6, including the dioxide layer 8 and the regions 18 and 22, is then heated under controlled conditions. As depicted in Figure 8, this heating process causes a silicon dioxide layer 24 to form in each of the the apertures 14 and 16. The heating process also causes the impurities in the regions 18 and 22 to diffuse downwardly through the epitaxial layer 4. In addition, impurities in the substrate 2 tend to diffuse upwardly toward the epitaxial layer 4. The temperature and duration of the heating process are controlled such that the high-concentration region 22 diffuses just into the low resistivity substrate 2 and actually contacts impurities which are diffusing upwardly from the substrate 2. Since the region 18 contains a lower concentration of impurities than the region 22, the region 18 diffuses only partially through the epitaxial layer 4.

The resulting diffused region 22 provides a low-resistance path from the substrate 2 through the high-resistivity epitaxial layer 4. The reduced resistance of the path enhances the finished device's immunity to latch-up when the device is used in a circuit design. Additional conventional processing steps (not shown) are thereafter used to complete the fabrication of the desired semiconductor components. A conventional contact pad (not shown) may be disposed in a desired location in electrical contact with the region 22.

## Claims

1. A method of making a semiconductor device upon a substrate (2), said device having a top surface which includes an electrical contact to the substrate, said method comprising the steps of:

    forming an epitaxial layer (4) upon the substrate;

    forming an insulating layer (8) upon the epitaxial layer;

    patterning the insulating layer to form at least one substrate contact aperture (14) and at least one semiconductor component aperture (16), said apertures extending through the insulating layer to the epitaxial layer;

    introducing impurities (18) through each of said apertures into the epitaxial layer;

    forming a temporary protective layer (20) over the semiconductor component aperture;

    introducing additional impurities (22) through only the substrate contact aperture into the epitaxial layer;

removing the temporary protective layer; and

diffusing the introduced impurities downwardly through the epitaxial layer such that the impurities disposed beneath the substrate contact aperture extend through the epitaxial layer to the substrate thereby providing a low resistance path between the substrate and the insulating layer, and the impurities disposed beneath the semiconductor component aperture extend only partially through the epitaxial layer, thereby providing a suitable region to form one or more semiconductor components.

2. The method as in claim 1 wherein said impurities are introduced by ion implantation.

3. The method as in claim 1 wherein the low resistance path is provided with an electrical contact adapted for use with a tape automated bonding process for electrically connecting the substrate to other devices.

**Revendications**

1. Procédé de fabrication d'un dispositif à semiconducteur sur un substrat (2), ledit dispositif ayant une face supérieure qui inclut un contact électrique avec le substrat, ledit procédé comprenant les étapes de :
   - formation d'une couche épitaxiale (4) sur le substrat;
   - formation d'une couche isolante (8) sur la couche épitaxiale;
   - impression de la couche isolante pour former au moins une ouverture de contact du substrat (14) et au moins une ouverture de composant à semiconducteur (16), lesdites ouvertures s'étendant à travers la couche isolante jusqu'à la couche épitaxiale;
   - introduction d'impuretés (18) à travers chacune desdites ouvertures dans la couche épitaxiale;
   - formation d'une couche protectrice temporaire (20) au-dessus de l'ouverture de composant à semiconducteur;
   - introduction d'impuretés additionnelles (22) seulement à travers l'ouverture de contact du substrat, dans la couche épitaxiale;
   - élimination de la couche protectrice temporaire; et
   - diffusion des impuretés introduites vers le bas, à travers la couche épitaxiale, de telle sorte que les impuretés disposées au-dessous de l'ouverture de contact du substrat s'étendent à travers la couche épitaxiale jusqu'au substrat, fournissant par ce moyen un chemin à faible résistance entre le substrat et la couche isolante, et que les impuretés disposées entre l'ouverture de composant à semiconducteur s'étendent seulement partiellement à travers la couche épitaxiale, fournissant par ce moyen une région convenant à la formation d'un ou de plusieurs composants à semiconducteurs.

2. Procédé selon la revendication 1, dans lequel lesdites impuretés sont introduites par implantation d'ions.

3. Procédé selon la revendication 1, dans lequel le chemin à faible résistance est muni d'un contact électrique adapté à l'utilisation avec un procédé de liaison automatisée par bande pour connecter électriquement le substrat à d'autres dispositifs.

**Patentansprüche**

1. Verfahren zum Herstellen einer Halbleitereinrichtung auf einem Substrat (2), wobei die Einrichtung eine obere Oberfläche hat, die einen elektrischen Kontakt mit dem Substrat aufweist, und das Verfahren die folgenden Schritte aufweist:
   Ausbilden einer Epitaxieschicht (4) auf dem Substrat;
   Ausbilden einer Isolationsschicht (8) auf der Epitaxieschicht;
   Strukturieren der Isolationsschicht, um zumindest eine Substratkontaktöffnung (14) und zumindest eine Halbleiterkomponentenöffnung (16) auszubilden, wobei die Öffnungen durch die Isolationsschicht zu der Epitaxieschicht verlaufen;
   Einführen von Verunreinigungen (18) durch jede der Öffnungen in die Epitaxieschicht;
   Ausbilden einer kurzzeitigen Schutzschicht (20) über der Halbleiterkomponentenöffnung;
   Einführen zusätzlicher Verunreinigungen (22) durch nur die Substratkontaktöffnung in die Epitaxieschicht;
   Entfernen der kurzzeitigen Schutzschicht; und
   Diffundieren der eingeführten Verunreinigungen nach unten in die Epitaxieschicht, so daß die Verunreinigungen, die unterhalb der Substratkontaktöffnung vorliegen, durch die Epitaxieschicht zu dem Substrat verlaufen, wodurch ein Weg mit niedrigem Widerstand zwischen dem Substrat und der Isolationsschicht erzeugt wird, und so daß die Verunreinigungen, die unterhalb der Halbleiterkomponentenöffnung vorliegen, nur teilweise durch die Epitaxieschicht verlaufen, wodurch ein geeigneter Bereich erzeugt wird, um eine oder mehrere Halbleiterkomponenten auszubilden.

2. Verfahren nach Anspruch 1, wobei die Verunreinigungen durch Ionenimplantation eingeführt werden.

3. Verfahren nach Anspruch 1, wobei der Weg niedrigen Widerstands mit einem elektrischen Kontakt versehen ist, der zum Einsatz mit einem bandautomatischen Bond-Prozeß für elektrisches Verbinden des Substrats mit anderen Einrichtungen ausgelegt ist.

FIG. 1

FIG. 2

FIG. 3

FIG. 7

FIG. 8

FIG.4

FIG.5

FIG.6